# EUROPÄISCHE PATENTSCHRIFT

(11) **EP 0 944 925 B1**
(45) Veröffentlichungstag und Bekanntmachung des Hinweises auf die Patenterteilung: **06.04.2005**
(21) Anmeldenummer: 97936595.4
(22) Anmeldetag: 05.08.1997
(51) Int. Cl.: H01L 41/04

(54) **VORRICHTUNG UND VERFAHREN ZUM ANSTEUERN EINES KAPAZITIVEN STELLGLIEDES**
PROCESS AND DEVICE FOR DRIVING A CAPACITIVE ACTUATOR
DISPOSITIF PROCEDE POUR LA COMMANDE D'UN ACTIONNEUR CAPACITIF

(30) Priorität: 14.08.1996 DE 19632872
(43) Veröffentlichungstag der Anmeldung: 29.09.1999
(73) Patentinhaber: Siemens Aktiengesellschaft, 80506 München (DE)
(72) Erfinder: HOFFMANN, Christian, D-93057 Regensburg (DE); FREUDENBERG, Hellmut, D-93080 Grossberg (DE); GERKEN, Hartmut, D-93152 Nittendorf (DE); BRASSEUR, Georg, A-1130 Wien (AT); PIRKL, Richard, D-93053 Regensburg (DE)
(86) Internationale Anmeldenummer: PCT/DE1997/001646
(87) Internationale Veröffentlichungsnummer: WO 1998/007199

(56) Entgegenhaltungen:
- EP-A- 0 464 443
- DE-A- 3 621 541

## Beschreibung

Die Erfindung betrifft eine Vorrichtung zum Ansteuern wenigstens eines kapazitiven Stellgliedes, insbesondere eines piezoelektrisch betriebenen Kraftstoffeinspritzventils einer Brennkraftmaschine gemäß den Merkmalen des Patentanspruchs 1 oder 2. Die Erfindung betrifft auch ein Verfahren zum Betreiben dieser Vorrichtung.

Aus EP 0 464 443 A1 ist ein Piezo-Stellglied bekannt, welches aus einem Kondensator über eine Ladespule geladen wird. Ein Teil der aufgebrachten Energie wird beim Entladen des Piezo-Stellgliedes über eine Entladespule in den Kondensator zurückgespeist, während der andere Teil ebenfalls über die Entladespule in Wärme umgewandelt wird. Beim Entladen liegt am Piezo-Stellglied eine negative Spannung.

Aus DE 36 21 541 C2 ist eine Treiberschaltung für ein Piezostellglied eines Kraftstoffeinspritzventils bekannt, welches über eine an einer Spannungsquelle liegende Reihenschaltung zweier Kondensatoren und eine Ladespule geladen und über eine Entladespule in einen der beiden Kondensatoren entladen wird. Bei einer alternativen Ausführung wird das Stellglied über einen an einer Spannungsquelle liegenden Kondensator und eine Ladespule geladen; beim Entladen wird die im Piezostellglied gespeicherten Energie über eine Entladespule vernichtet.

Der Erfindung liegt die Aufgabe zugrunde, eine möglichst verlustarm arbeitende und einfach aufgebaute Vorrichtung zum Ansteuern wenigstens eines kapazitiven Stellgliedes zu schaffen, bei welcher auch unterschiedliche Sollwerte für die am Stellglied auftretende Spannung vorgebbar sind und bei der negative Spannungen am Stellglied vermieden werden.

Diese Aufgabe wird erfindungsgemäß durch die Merkmale des Patentanspruchs 1 oder 2 gelöst. Vorteilhafte Ausgestaltungen der Erfindung sind den Unteransprüchen zu entnehmen.

Ausführungsbeispiele der Erfindung sind im folgenden unter Bezugnahme auf die schematische Zeichnung näher erläutert. Es zeigen:
- Figur 1:: die Schaltung eines erstes Ausführungsbeispiels,
- Figur 2:: ein Flußdiagramm, betreffend die Arbeitsweise des Ausführungsbeispiels nach Figur 1,
- Figur 3:: die Schaltung eines zweiten Ausführungsbeispiels, und
- Figur 4:: die Schaltung eines dritten Ausführungsbeispiels.

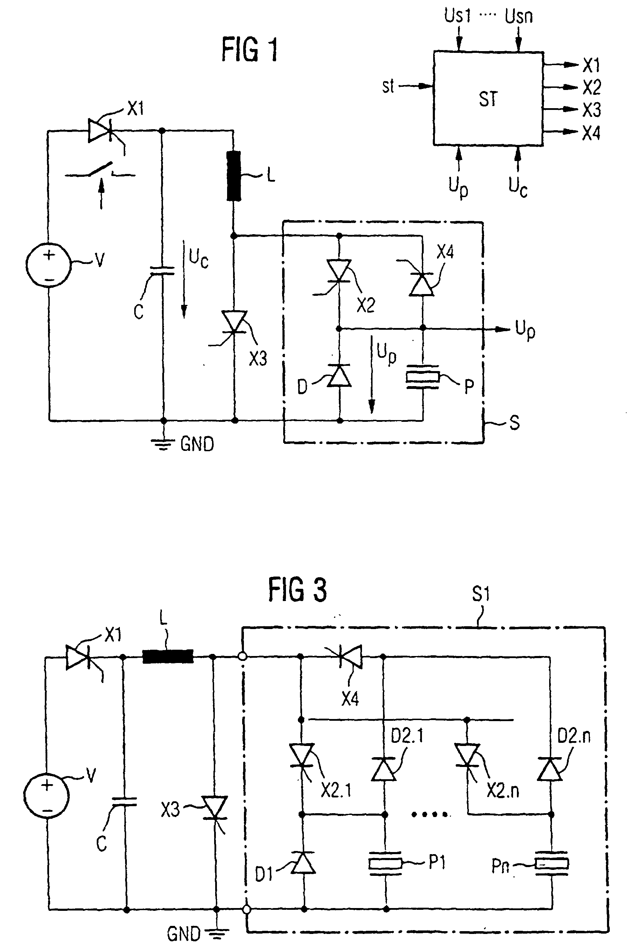

Figur 1 zeigt eine Prinzipschaltung zum Ansteuern eines einzelnen, weiter nicht dargestellten Kraftstoffeinspritzventils einer Brennkraftmaschine über ein piezoelektrisches Stellglied P, mittels einer üblicherweise mikroprozessorgesteuerten Steuerschaltung ST.

Zwischen dem Pluspol +V und dem Minuspol GND einer Energiequelle V liegt eine Reihenschaltung eines Ladekondensators C und eines gesteuerten, elektronischen, nur in einer Richtung stromdurchlässigen Energieschalters X1.

In der weiteren Beschreibung, wenn von Schaltern X1 bis X4 die Rede ist, handelt es sich um elektronische, nur in einer Richtung stromdurchlässige, aus wenigstens einem Halbleiterelement bestehende Schalter, vorzugsweise Thyristorschalter, die von der Steuerschaltung ST angesteuert werden.

In stromleitendem Zustand des Energieschalters X1 wird der Ladekondensator C von der Energiequelle V aufgeladen. Das kann prinzipiell geschehen, solange die Spannung Uc am Ladekondensator kleiner als die Spannung der Energiequelle V ist.

Parallel zum Ladekondensator C liegt eine Reihenschaltung aus einer mit dem Energieschalter X1 verbundenen Umschwingspule L und einem Ladestopschalter X3, dessen Funktion später erklärt wird.

Parallel zum Ladestopschalter X3 ist eine Stellgliedschaltung S angeordnet, die eine Reihenschaltung aus einer Parallelschaltung eines in Richtung von der Umschwingspule L weg stromdurchlässigen Ladeschalters X2 und eines in Richtung zur Umschwingspule hin stromdurchlässigen Entladeschalters X4 und aus einer Parallelschaltung des Stellgliedes P mit einer Diode D aufweist, die in Richtung zum Ladeschalter X2 hin stromdurchlässig ist.

Die Schalter X1 bis X4 werden von einer mikroprozessorgesteuerten Steuerschaltung ST abhängig von externen Steuersignalen st, von in diesem Ausführungsbeispiel einem vorgegebenen Sollwert Us (es können auch mehrere sein, die nacheinander zur Wirkung kommen, z.B. für Vor- und Haupteinspritzung von Kraftstoff) für die am Stellglied P anliegende Spannung und vom Istwert Up dieser Spannung gesteuert. Statt der Stellgliedspannung kann auch die Position des Stellgliedes herangezogen werden.

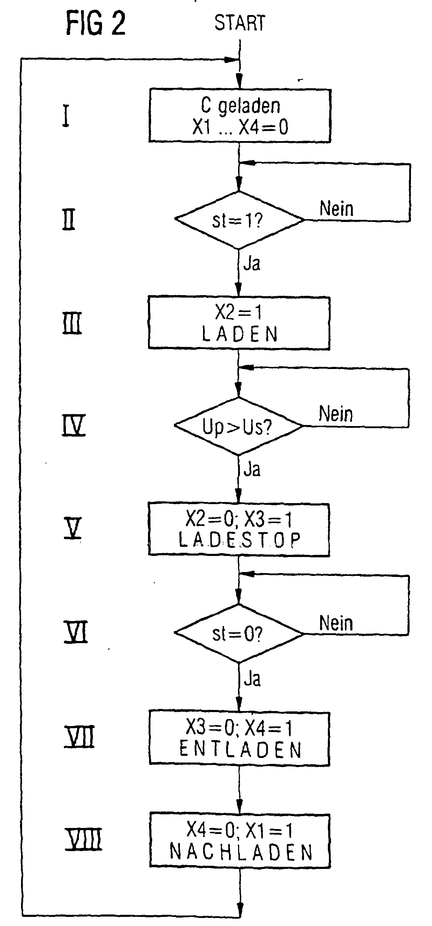

Anhand des in Figur 2 gezeigten Flußdiagramms wird ein Verfahren zum Betreiben der Vorrichtung am Beispiel der Schaltung nach Figur 1 beschrieben, ausgehend von einem Anfangszustand (Zustand I), in welchem der Ladekondensator C voll geladen ist, sämtliche Schalter X1 bis X4 nichtleitend sind und die Umschwingspule L stromlos ist.

Mit dem Beginn eines externen Steuersignals st = 1 (Zustand II) wird der Ladeschalter X2 gezündet (stromleitend gesteuert). Damit beginnt der Ladekondensator C, sich über die Umschwingspule L in das (wie ein Kondensator wirkende) Stellglied zu entladen und dieses aufzuladen (Zustand III), was sich als Längenänderung des Piezostellgliedes auswirkt. Die am Stellglied anliegende Spannung Up, die der Steuerschaltung ST mitgeteilt wird (in Figur 1 durch Pfeile angedeutet), steigt an.

Sobald die Spannung Up den Sollwert Us erreicht (Zustand IV), wird der Ladevorgang beendet, der Ladeschalter X2 wird nichtleitend, d.h., X2 = 0, und der Ladestopschalter X3 wird leitend (X3 = 1, Zustand V). Der Schwingkreis L-C schwingt weiter, bis die Umschwingspule L stromlos ist.

Der Ladezustand des Stellgliedes bleibt erhalten, solange das Steuersignal st anliegt. Wenn es verschwindet (st = 0, Zustand VI), muß das Stellglied entladen werden. Dazu wird der-Ladedstopschalter nichtleitend gesteuert, X3 = 0, und der Entladeschalter leitend, X4 = 1 (Zustand VII). Nun entlädt sich das Stellglied P über die Umschwingspule L in den Ladekondensator C. Ist das Stellglied bis auf die Schwellspannung der Diode D entladen, übernimmt diese den Strom; der Schwingkreis L-C schwingt weiter, bis die Umschwingspule stromlos ist. Schalter X4 wird nichtleitend gesteuert.

Ohne Verluste läge am Ladekondensator C nun die gleiche Spannung Uc wie im Anfangszustand I. Tatsächlich ist sie aber infolge von Verlusten etwas kleiner geworden, sodaß in diesem Ausführungsbeispiel nach Beendigung des Entladevorgangs, wenn die Schalter X2 bis X4 wieder nichtleitend sind, der Energieschalter X1 zum Nachladen des Ladekondensators C leitend geschaltet wird (Zustand VIII), bevor ein neuer Ladezyklus beginnt.

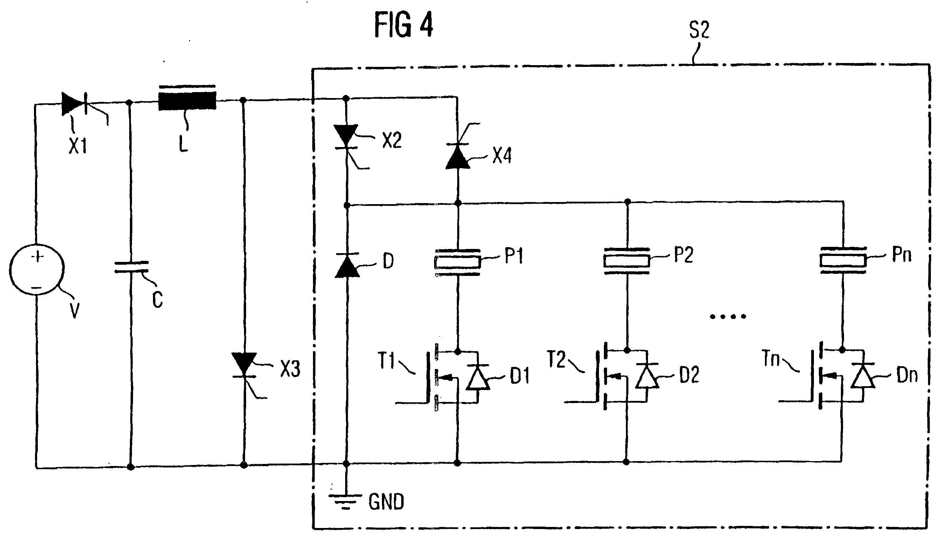

In Figur 3 ist eine im Prinzip der Schaltung nach Figur 1 entsprechende Schaltung, jedoch für die Ansteuerung mehrerer Stellglieder P1 bis Pn gezeigt. In dieser Schaltung sind Energiequelle V, Energieschalter X1, Ladekondensator C, Umschwingspule und Ladestopschalter X3 wie bei der Schaltung nach Figur 1 geschaltet und wirken ebenso, wie dort beschrieben. Die Steuerschaltung ST ist jedoch hier nicht wieder dargestellt.

Für das erste Stellglied P1 weist die Stellgliedschaltung S1 mit dem Ladeschalter X2.1 statt X2, der Diode D und dem Entladeschalter X4 die gleiche Schaltung wie in Figur 1 auf, mit dem Unterschied, daß zwischen Stellglied P1 und Entladeschalter X4 eine zum Entladeschalter hin stromleitende Diode D2.1 geschaltet ist, die für die Ansteuerung nur eines Stellgliedes nach Figur 1 nicht erforderlich ist und daß für jedes weitere Stellglied P2 bis Pn ein weiterer Ladeschalter X2.2 bis X2.n und eine weitere Diode D2.2 bis D2.n in entsprechender Schaltung vorgesehen sind.

Die von der Steuerschaltung angesteuerten Ladeschalter X2.1 bis X2.n wählen das zu ladende Stellglied aus, während die Dioden D2.1 bis D2.n verhindern, daß außer dem ausgewählten Stellglied auch andere Stellglieder geladen werden. Die Entladung jedes Stellgliedes erfolgt über die ihm zugeordnete Diode D2.1 bis D2.n, wenn der gemeinsame Entladeschalter X4 leitend gesteuert ist. Ist das jeweilige Stellglied bis auf die Schwellspannung der Diode D entladen, übernimmt diese den Strom; der Schwingkreis L-C schwingt weiter, bis die Umschwingspule L stromlos ist.

Figur 4 zeigt eine weitere Schaltung zum Ansteuern mehrerer Stellglieder, die einen reduzierten Bauteileaufwand gegenüber der Schaltung nach Figur 3 aufweisen. Die Steuerschaltung ST ist auch hier nicht wieder dargestellt.

Bei der Schaltung nach Figur 3 ist zum Zünden jedes der Thyristorschalter X2.1 bis X2.n ein teurer Übertrager erforderlich. Diese Übertrager sind entbehrlich, wenn man an ihrer Stelle einfache Auswahlschalter T1 bis Tn verwendet, beispielsweise Power-MOSFET-Schalter. Dann reduziert sich die Schaltung im wesentlichen auf eine der Schaltung nach Figur 1 entsprechende Schaltung, bei der das Stellglied P durch eine Reihenschaltung aus Stellglied P1 und zugeordnetem Auswahlschalter T1 ersetzt ist, wobei der Schaltstrecke des Auswahlschalters T1 eine in Entladerichtung stromdurchlässige Diode D1 parallelgeschaltet ist, die bei Verwendung von MOSFET-Schaltern in diesen bereits integriert ist.

Für jedes weitere Stellglied P2 bis Pn ist eine derartige Reihenschaltung aus einem Stellglied P2 bis Pn, einem Auswahlschalter T2 bis Tn und einer Diode D2 bis Dn der Reihenschaltung P1-T1-D1 für das erste Stellglied P1 parallelgeschaltet.

Die Funktionsweise dieser Schaltung entspricht derjenigen der Schaltungen nach den Figuren 1 und 3, wobei beim Laden eines Stellgliedes, beispielsweise P1, der zugeordnete Auswahlschalter T1 mindestens solange leitend gesteuert sein muß, wie der Ladeschalter X2 leitend gesteuert ist.

Beim Entladen des Stellgliedes P1 fließt der Strom vom Stellglied über Entladeschalter X4, Umschwingspule L, Ladekondensator C und Diode D1. Ist das Stellglied bis auf die Schwellspannung der Diode D entladen, übernimmt diese den Strom und der Schwingkreis L-C schwingt weiter, bis die Umschwingspule stromlos ist.

Die in den Figuren 1, 3 und 4 gezeigten Schaltungen können durch einfache Umstellungen sowohl der Lade- und Entlade-Schalter als auch der Auswahlschalter so ausgeführt werden, daß die Stellglieder, je nach Vorgaben, entweder mit dem Minuspol GND verbunden sind (Lowside, siehe Figuren 1 und 3) oder näher am Pluspol +V liegen (Highside, siehe Figur 4).

## Patentansprüche

1. Vorrichtung zum Ansteuern wenigstens eines kapazitiven Stellgliedes (P),
- mit einem zwischen Pluspol (+V) und Minuspol (GND) einer Energiequelle (V) angeordneten Ladekondensator (C), der von der Energiequelle (V) über einen Energieschalter (X1) aufladbar ist,
- mit einer parallel zum Ladekondensator (C) angeordneten Reihenschaltung aus einer mit dem Energieschalter (X1) verbundenen Umschwingspule (L) und einem Ladestopschalter (X3), und
- mit einer parallel zum Ladestopschalter (X3) angeordneten Stellgliedschaltung (S, S1), bestehend
- aus einem auf der einen Seite mit der Umschwingspule (L) verbundenen, zu ihr hin stromleitenden Entladeschalter (X4),
- für jedes Stellglied aus einer Reihenschaltung aus einem mit der Umschwingspule (L) verbundenen, von ihr weg stromleitenden Ladeschalter (X2.1 bis X2.n) und dem Stellglied (P1 bis Pn) selbst, und aus einer zwischen dem Stellglied (P1 bis Pn) und der anderen Seite des Entladeschalters (X4) angeordneten, in Entladerichtung stromleitenden Diode (D2.1 bis D2.n), und
- aus einer zu einem der Stellglieder (P1) parallelgeschalteten Diode (D), die in Richtung zu.dem dem Stellglied zugeordneten Ladeschalter (X2.1) hin stromdurchlässig ist.

2. Vorrichtung zum Ansteuern wenigstens eines kapazitiven Stellgliedes (P1 bis Pn) mittels einer Steuerschaltung (ST), insbesondere eines piezoelektrisch betriebener Kraftstoffeinspritzventils einer Brennkraftmaschine,
- mit einem zwischen Pluspol (+V) und Minuspol (GND) einer Energiequelle (V) angeordneten Ladekondensator (C), der von der Energiequelle (V) über einen Energieschalter (X1) aufladbar ist,
- mit einer parallel zum Ladekondensator (C) angeordneten Reihenschaltung aus einer mit dem Energieschalter (X1) verbundenen Umschwingspule (L) und einem Ladestopschalter (X3),
- mit einer parallel zum Ladestopschalter (X3) angeordneten Stellgliedschaltung (S2), die eine Reihenschaltung aus einer Parallelschaltung eines zur Umschwingspule (L) hin stromdurchlässigen Entladeschalters (X4) und einer von der Umschwingspule (L) weg stromdurchlässigen Ladeschalters (X2) und aus einer Diode (D) beinhaltet, und
- mit einer für jedes Stellglied (P1 bis Pn) vorgesehenen, parallel zur Diode (D) angeordneten Reihenschaltung aus dem Stellglied (P1 bis Pn) selbst und aus einem ihm zugeordneten, von der Steuerschaltung (ST) gesteuerten elektronischen Auswahlschalter (T1 bis Tn), dessen Schaltstrecke durch eine in Entladerichtung stromleitende Diode Dl bis Dn überbrückt ist.

3. Vorrichtung nach einem der Ansprüche 1 oder 2, **dadurch gekennzeichnet, daß** Energieschalter (X1), Ladeschalter (X2, X2*, X2.1 bis X2.n) und Entladeschalter (X4, X4*) aus gesteuerten, elektronischen, nur in einer Richtung stromdurchlässigen Schaltern mit wenigstens einem Halbleiterelement bestehen.

4. Vorrichtung nach einem der Ansprüche 1 oder 2, **dadurch gekennzeichnet, daß** wenigstens ein Sollwert (Us1 bis Usn) für die Position des jeweiligen Stellgliedes (P, P1 bis Pn) oder für die an ihm liegende Spannung (Up) der Steuerschaltung (ST) vorgebbar oder in ihr gespeichert ist, und
- daß die Steuerschaltung (ST) die Steuerbefehle für die Ladeschalter (X2, X2.1 bis X2.n), Ladestopschalter (X3), Entladeschalter(X4) und Auswahlschalter (T1 bis Tn) abhängig von externen Steuersignalen (st), von der Position des jeweiligen Stellgliedes (P, P1 bis Pn) oder der an ihm liegenden Spannung (Up) und von dem jeweils vorgegebenen Sollwert (Us1 bis Usn) für Position oder Spannung des Stellgliedes ausgibt.

5. Verfahren zum Betreiben der Vorrichtung nach einem der Ansprüche 1 oder 2, **dadurch gekennzeichnet,**
**daß** mit dem Beginn eines Steuersignals (st) das anzusteuernde Stellglied (P, P1 bis Pn) aus dem von der Energiequelle (V) geladenen Ladekondensator (C) über die Umschwingspule (L) solange aufgeladen wird, bis die an ihm anliegende Spannung (Up) einen vorgegebenen Sollwert (Us) erreicht,
**daß** anschließend dieser Ladezustand (Up = Us) bis zum Ende des Steuersignals (st) aufrecht erhalten wird,
**daß** mit dem Ende des Steuersignals (st) das Stellglied in den Ladekondensator (C) entladen wird, und
**daß** anschließend an den Entladevorgang der Ladekondensator (C) von der Energiequelle (V) wieder aufgeladen wird.

## Claims

1. Device for driving at least one capacitive actuator (P),
- having a charging capacitor (C), which is arranged between the positive pole (+V) and negative pole (GND) of an energy source (V) and can be re-charged by the energy source (V) via an energy switch (X1)
- having a series circuit, which is arranged in parallel with the charging capacitor (C) and comprises a ring-around coil (L), connected to the energy switch (X1), and a charging stop switch (X3), and
- having an actuator circuit (S, S1) arranged in parallel with the charging stop switch (X3), comprising
- a discharging switch (X4), which is connected on one side to the ring-around coil (L) and conducts current to it,
- for each actuator, a series circuit composed of a charging switch (X2.1 to X2.n), which is connected to the ring-around coil (L) and conducts current away from it, and the actuator (P1 to Pn) itself, and a diode (D2.1 to D2.n), which is arranged between the actuator (P1 to Pn) and the other side of the discharging switch (X4) and conducts current in the discharging direction, and
- a diode (D) which is connected in parallel with one of the actuators (P1) and passes current in the direction of the charging switch (X2.1) assigned to the actuator.

2. Device for driving at least one capacitive actuator (P1 to Pn) by means of a control circuit (ST), in particular a piezoelectrically operated fuel injection valve of an internal combustion engine,
- having a charging capacitor (C), which is arranged between the positive pole (+V) and negative pole (GND) of an energy source (V) and can be re-charged by the energy source (V) via an energy switch (XI),
- having a series circuit, which is arranged in parallel with the charging capacitor (C) and comprises a ring-around coil (L), connected to the energy switch (X1), and a charging stop switch (X3),
- having an actuator circuit (S2) which is arranged in parallel with the charging stop switch (X3) and contains a series circuit composed of a parallel circuit of a discharging switch (X4), which passes current to the ring-around coil (L), and a charging switch (X2), which passes current away from the ring-around coil (L), and of a diode (D), and
- having a series circuit, provided for each actuator (P1 to Pn) and arranged in parallel with the diode (D), which is composed of the actuator (P1 to Pn) itself and of an electronic selector switch (T1 to Tn), which is assigned to said actuator, is controlled by the control circuit (ST) and whose switching junction is bridged by a diode D1 to Dn which conducts current in the discharging direction.

3. Device according to one of Claims 1 or 2, **characterized in that** the energy switch (X1), charging switch (X2, X2*, X2.1 to X2.n) and discharging switch (X4, X4*) comprise controlled, electronic switches which pass current only in one direction and have at least one semiconductor element.

4. Device according to one of Claims 1 or 2, **characterized in that** at least one desired value (Us1 to Usn) for the position of the respective actuator (P, P1 to Pn) or for the voltage (Up) present across it can be prescribed for the control circuit (ST) or stored in it, and
- **in that** the control circuit (ST) outputs the control commands for the charging switches (X2, X2.1 to X2.n), charging stop switch (X3), discharging switch (X4) and selector switches (T1 to Tn) as a function of external control signals (st) from the position of the respective actuator (P, P1 to Pn) or of the voltage (Up) present across it, and from the respectively prescribed desired value (Us1 to Usn) for the position or voltage of the actuator.

5. Method for operating the device according to one of Claims 1 or 2, **characterized**
**in that** with the start of a control signal (st) the actuator (P, P1 to Pn) to be driven is recharged from the charging capacitor (C), charged by the energy source (V) via the ring-around coil (L) until the voltage (Up) present across it reaches a prescribed desired value (Us),
**in that** subsequently this state of charge (Up = Us) is maintained up to the end of the control signal (st),
**in that** with the end of the control signal (st) the actuator is discharged into the charging capacitor (C), and
**in that** the charging capacitor (C) is recharged by the energy source (V) following the discharging operation.

## Revendications

1. Dispositif pour commander au moins un actionneur capacitif (P), comprenant
- un condensateur de charge (C) disposé entre le pôle positif (+V) et le pôle négatif (GND) d'une source d'énergie (V), ce condensateur pouvant être chargé à partir de la source d'énergie (V) à travers un interrupteur d'énergie (X1),
- un circuit en série, disposé en parallèle au condensateur de charge (C), comprenant une bobine oscillatrice (L) reliée à l'interrupteur d'énergie (X1) et un interrupteur d'arrêt de charge (X3), et
- un circuit d'actionneur (S, S1) disposé en parallèle à l'interrupteur d'arrêt de charge (X3), ce circuit d'actionneur étant composé
- d'un interrupteur de décharge (X4) relié sur un côté à la bobine oscillatrice (L) et étant conducteur de courant dans cette direction,
- pour chaque actionneur, d'un circuit en série comportant un interrupteur de charge (X2.1 à X2.n) et l'actionneur (P1 à Pn) lui-même, relié à la bobine oscillatrice (L) et conducteur en courant dans la direction opposée à cette bobine, et d'une diode (D2.1 à D2.n) disposée entre l'actionneur (P1 à Pn) et l'autre côté de l'interrupteur de décharge (X4), et
- d'une diode (D) reliée en parallèle à un des actionneurs (P1), cette diode étant conductrice de courant dans la direction de l'interrupteur de charge (X2.1) associé à l'actionneur.

2. Dispositif pour commander au moins un actionneur capacitif (P1 à Pn), en particulier une soupape d'injection de carburant à commande piézo-électrique d'un moteur à combustion interne, au moyen d'un circuit de commande (ST), comprenant
- un condensateur de charge (C) connecté entre le pôle positif (+V) et le pôle négatif (GND) d'une source d'énergie (V), qui peut être rechargé par la source d'énergie (V) par l'intermédiaire d'un interrupteur d'énergie (X1),
- un circuit en série, connecté en parallèle au condensateur de charge (C), d'une bobine oscillatrice (L) reliée à l'interrupteur d'énergie (X1) et d'un interrupteur d'arrêt de charge (X3),
- un circuit d'actionneur (S2), connecté en parallèle à l'interrupteur d'arrêt de charge (X3), comprenant un circuit en série composé (a) d'un circuit en parallèle d'un interrupteur de décharge (X4), pouvant conduire le courant en direction de la bobine oscillatrice (L), et d'un interrupteur de charge (X2) pouvant conduire le courant en direction opposée à la bobine oscillatrice (L), et (b) d'une diode (D),
- un circuit en série prévu pour chaque actionneur (P1 à Pn) et connecté en parallèle à la diode (D), comprenant l'actionneur (P1 à Pn) lui-même et un interrupteur sélectionneur électronique (T1 à Tn) associé à l'actionneur et commandé par le circuit de commande (ST), la distance de contact de l'interrupteur sélectionneur étant pontée par une diode (D1 à Dn) conductrice en direction de décharge.

3. Dispositif selon l'une des revendications 1 ou 2, **caractérisé en ce que** l'interrupteur d'énergie (X1), l'interrupteur de charge (X2, X2*, X2.1 à X2.n) et l'interrupteur de décharge (X4, X4*) sont réalisés par des interrupteurs électroniques ne pouvant être conducteurs que dans une seule direction et comportant au moins un élément semi-conducteur.

4. Dispositif selon l'une des revendications 1 ou 2, **caractérisé en ce qu'**au moins une valeur de consigne (Us1 à Usn) peut être prescrite pour la position d'un actionneur respectif (P, P1 à Pn) ou pour la tension (Up) du circuit de commande (ST) appliquée à l'actionneur ou enregistrée dans le circuit de commande, et
- que le circuit de commande (ST) fournit les instructions de commande pour les interrupteurs de charge (X2, X2.1 à X2.n), l'interrupteur d'arrêt de charge (X3), l'interrupteur de décharge (X4) et les interrupteurs sélectionneurs (T1 à Tn) en fonction de signaux de commande externes (st), de la position de l'actionneur respectif (P, P1 à Pn) ou de la tension (Up) appliquée à celui-ci et de la valeur de consigne respective prescrite (Us1 à Usn) concernant la position ou la tension de l'actionneur.

5. Procédé pour la mise en oeuvre du dispositif selon l'une des revendications 1 ou 2, **caractérisé en ce**
**que** l'actionneur à exciter (P, P1 à Pn) est chargé lors du commencement d'un signal de commande (st), à partir du condensateur de charge (C) chargé par la source d'énergie (V) par l'intermédiaire de la bobine oscillatrice (L) jusqu'à ce que la tension (Up) appliquée à l'actionneur est arrivée à une valeur de consigne (Us) prescrite,
**que** cet état de charge (Up = Us) est ensuite maintenu jusqu'à la fin du signal de commande (st),
**que** l'actionneur est déchargé dans le condensateur de charge (C) à la fin du signal de commande (st), et
**que** le condensateur de charge (C) est rechargé par la source d'énergie (V) après le processus de décharge.
